# EUROPEAN PATENT APPLICATION

(11) **EP 4 645 369 A1**
(43) Date of publication of application: **05.11.2025**
(21) Application number: 23909165.5
(22) Date of filing: 03.08.2023
(51) Int. Cl.: H01L 21/04, H01L 21/3065, H01L 21/308, H01L 21/311, H01L 21/67

(54) **ETCHING METHOD AND ETCHING SYSTEM**

(30) Priority: 30.12.2022 CN 202211739675
(71) Applicant: Jiangsu Leuven Instruments Co., Ltd., Xuzhou, Jiangsu 221300 (CN)
(72) Inventor: LI, Peipei, Xuzhou, Jiangsu 221300 (CN); GUO, Chunxiang, Xuzhou, Jiangsu 221300 (CN); REN, Zhouyi, Xuzhou, Jiangsu 221300 (CN); PENG, Taiyan, Xuzhou, Jiangsu 221300 (CN); XU, Kaidong, Xuzhou, Jiangsu 221300 (CN)
(74) Representative: Eisenführ Speiser
(86) International application number: PCT/CN2023/110887
(87) International publication number: WO 2024/139223

(57) **Abstract**

An etching method and an etching system. The etching method comprises: providing a structure to be etched (101), wherein said structure (101) is covered with a patterned mask layer (102); modifying an exposed surface of said structure (101) by taking the mask layer (102) as a mask and using an oxidizing gas, so as to form a modified layer (103); and removing the modified layer (103) by taking the mask layer (102) as a mask and using an etching gas, so as to form a trench (104).

## Description

The present application claims the priority to the Chinese Patent Application No. 202211739675.9, titled "ETCHING METHOD AND ETCHING SYSTEM", filed on December 30, 2022 with the China National Intellectual Property Administration, which is incorporated herein by reference in its entirety.

### FIELD

The present application relates to the technical field of semiconductors and, in particular, to an etching method and an etching system.

### BACKGROUND

Silicon carbide (SiC), as a representative material of third-generation semiconductors, is widely used in various applications such as communications, new energy vehicles, high-speed trains, industrial automation, and satellite communications. Semiconductor devices fabricated from silicon carbide not only operate stably at high temperatures and are suitable for high-voltage and high-frequency scenarios, but also achieve high operational capabilities with low electrical energy consumption.

In the fabrication of silicon carbide devices, etching process is crucial for achieving high-performance devices. When etching silicon carbide materials, a microtrenching effect occurs. Specifically, a V-shaped groove, that is, a micro-trench, will be formed at a bottom of a sidewall of a trench, which is undesirable. This can affect the working reliability and service life of the devices. Therefore, it is desired to provide high-performance devices by achieving precise and controllable etching of the silicon carbide materials.

### SUMMARY

In view of this, an object of the present application is to provide an etching method and an etching system, which can achieve precise and controllable etching amount, and avoid the formation of micro-trenches, thereby enhancing device performance. The specific solutions are as follows.

In a first aspect, an etching method is provided according to the present application, including:
providing a structure to be etched, wherein the structure to be etched is covered with a patterned mask layer;
modifying an exposed surface of the structure to be etched by using an oxidizing gas while taking the mask layer as a shield, so as to form a modified layer; and
removing the modified layer by using an etching gas while taking the mask layer as the shield, so as to form a trench.

In a second aspect, an etching system is provided according to the present application, including an etching apparatus and a controller.

The etching apparatus is configured to modify an exposed surface of a structure to be etched by using an oxidizing gas to form a modified layer and to remove the modified layer by using an etching gas to form a trench. The controller is configured to execute the etching method.

An etching method and an etching system are provided according to embodiments of the present application. A structure to be etched is provided, and is covered with a patterned mask layer. An exposed surface of the structure to be etched is modified by using an oxidizing gas while taking the mask layer as a shield, so as to form a modified layer. Subsequently, the modified layer is removed by using an etching gas while taking the mask layer as a shield, so as to form a trench. In this way, by firstly forming the modified layer and then removing it to form the trench, unmodified portions of the structure to be etched are hardly etched, allowing the etching process to stop at an appropriate position and achieving precise and controllable etching amount. Furthermore, since the trench is formed by etching the modified layer, the unmodified portions of the structure to be etched are not over-etched, which also avoids the formation of micro-trenches, thereby reducing electrical damage and enhancing device performance.

### BRIEF DESCRIPTION OF THE DRAWINGS

For clear illustration of the technical solutions according to embodiments of the present application or conventional techniques, drawings will be briefly described below, which are used in description of the embodiments of the present application or conventional techniques. Apparently, the drawings in the following descriptions only illustrate some embodiments of the present application, and other drawings may be obtained by those skilled in the art based on the provided drawings without creative efforts.
FIG. 1 shows a flow chart of an etching method provided according to an embodiment of the present application;
FIG. 2 shows a schematic structural view of a structure to be etched provided according to an embodiment of the present application;
FIG. 3 shows a schematic structural view of a structure to be etched provided according to another embodiment of the present application;
FIG. 4 shows a schematic structural view of a modified layer formed in the structure to be etched provided according to an embodiment of the present application;
FIG. 5 shows a schematic structural view of a trench formed in the structure to be etched provided according to an embodiment of the present application;
FIG. 6 shows an electron microscope image of a part of a trench provided according to an embodiment of the present application;
FIG. 7 shows an electron microscope image of a trench etched by ICP (Inductively Coupled Plasma) process provided according to an embodiment of the present application;
FIG. 8 shows an electron microscope image of the trench etched by ALE (Atomic Layer Etching) process which follows ICP etching provided according to an embodiment of the present application; and
FIG. 9 shows a schematic structural view of an etching system provided according to an embodiment of the present application.

### DETAILED DESCRIPTION OF THE EMBODIMENTS

In order to make the above objects, features, and advantages of the present application more apparent and understandable, specific implementations of the present application are described in detail below in conjunction with the drawings.

Various specific details are set forth in following description to facilitate a full understanding of the present application. The present application may be implemented in a manner different from those described herein, and those skilled in the art may perform analogous promotion without departing from concepts of the present application. Therefore, the present application is not limited by the specific embodiments disclosed hereinafter.

The present application would be described in detail in conjunction with schematic diagrams. In following description, a cross-sectional view of a device structure may be partially enlarged not according to a general scale in order to facilitate illustration. The schematic views are only examples and are not intended for limiting a protection scope of the present application. In addition, three spatial dimensions such as a length, a width, and a depth shall be configured in practice.

As described in the background, a V-shaped groove, that is, a micro-trench, may be formed at a bottom of a sidewall of a trench, which is undesirable. This may affect the working reliability and service life of the devices. Therefore, it is desired to provide high-performance devices by achieving precise and controllable etching of silicon carbide materials.

Based on the above technical issues, an etching method and an etching system are provided according to embodiments of the present application. A structure to be etched is provided, and is covered with a patterned mask layer. An exposed surface of the structure to be etched is modified by using an oxidizing gas while taking the mask layer as shield, so as to form a modified layer. Subsequently, under shield of the mask layer, the modified layer is removed by using an etching gas, so as to form a trench. In this way, by firstly forming the modified layer and then removing it to form the trench, unmodified portions of the structure to be etched are hardly etched, allowing the etching process to stop at an appropriate position and achieving precise and controllable etching amount. Furthermore, since the trench is formed by etching the modified layer, the unmodified portions of the structure to be etched are not over-etched, which also avoids the formation of micro-trenches, thereby reducing electrical damage and enhancing device performance.

For ease of understanding, an etching method and an etching system provided according to embodiments of the present application will be described in detail below with reference to the drawings.

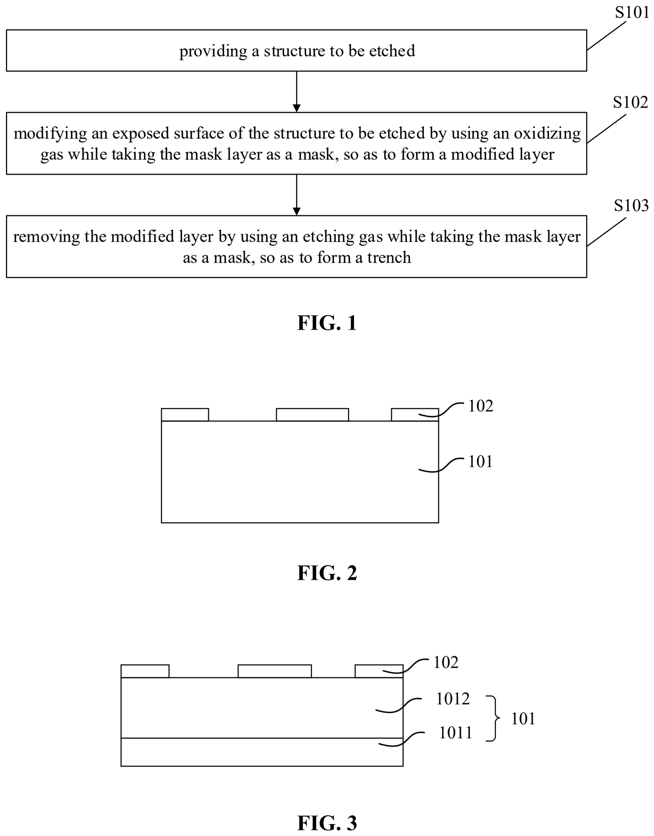

Referring to FIG. 1, it shows a flow chart of an etching method provided according to an embodiment of the present application. The method may include the following steps.

At S101, a structure to be etched is provided.

In the embodiments of the present application, a structure to be etched may be provided, and covered with a patterned mask layer, so as to etch the structure based on the pattern of the mask layer, thereby obtaining a patterned etched structure. The size and shape of the structure to be etched are not specifically limited herein.

Specifically, the structure to be etched may be a silicon carbide substrate. Referring to FIG. 2, it is a schematic structural view of a structure to be etched provided according to an embodiment of the present application. The structure 101 to be etched is a silicon carbide substrate, and a patterned mask layer 102 is covered on one side of the silicon carbide substrate.

Alternatively, the structure to be etched may be a substrate with a silicon carbide layer on one side thereof, and the silicon carbide layer may be subsequently etched based on the patterned mask layer. The substrate may be, for example, a silicon substrate. Referring to FIG. 3, it shows a schematic structural view of a structure to be etched provided according to another embodiment of the present application. The structure to be etched includes a substrate 1011 and a silicon carbide layer 1012 stacked one on top of another, and a mask layer 102 is covered on one side of the silicon carbide layer 1012.

In a possible implementation, the patterned mask layer may be formed on the structure to be etched by using nanoimprinting, photolithography, or etching process. The material of the mask layer may be at least one of photoresist, silicon oxide, silicon nitride, and metal. The critical dimension (CD) of the mask layer may be 1 µm.

Specifically, nanoimprinting transfers patterns through contact printing, thereby forming a patterned mask layer on the structure to be etched. The nanoimprinting process is simple, cost-effective, suitable for mass production, and produces patterns with high resolution. Photolithography involves coating the surface of the structure to be etched with a layer of highly photosensitive photoresist, illuminating the surface of the structure to be etched through a mask with light, causing a reaction in the photoresist exposed to light, and then using a specific solvent to remove either the exposed or unexposed photoresist, thus transferring the circuit pattern from the mask to the structure to be etched with higher resolution.

In a possible implementation, the structure to be etched may be placed in a reaction chamber so as to facilitate modification and etching processes in the reaction chamber. Alternatively, the modification and etching processes may be carried out in separate reaction chambers. The reaction chamber where the structure to be etched is placed may be a chamber of an Inductive Coupled Plasma (ICP) processing equipment, a Capacitively Coupled Plasma (CCP) processing equipment, or any other processing equipment. ICP processing equipment introduces the energy of a radio frequency power supply into the reaction chamber in a form of magnetic field coupling through an inductive coil, generating plasma for etching or deposition. CCP processing equipment forms the plasma in the reaction chamber through capacitive coupling of a radio frequency or direct current power supply applied to the electrodes, achieving etching or deposition.

At S102, an exposed surface of the structure to be etched is modified by using an oxidizing gas while taking the mask layer as shield, so as to form a modified layer.

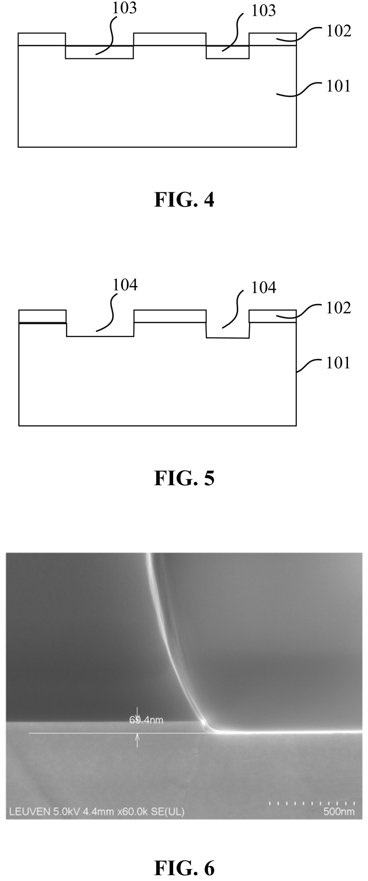

In an embodiment of the present application, the mask layer may be used as a shield, and an exposed surface of the structure to be etched may be modified by using an oxidizing gas to form a modified layer. The modified layer is characterized by uniform thickness, high uniformity, and self-limiting properties, which facilitates precise control of the etching when subsequently etching the modified layer to form trenches. With reference to FIG. 4, it shows a schematic structural view of a modified layer formed in the structure to be etched provided by an embodiment of the present application. The modified layer 103 is formed in the exposed regions of the structure to be etched.

Specifically, if the structure to be etched includes silicon carbide material, the oxidizing gas may include at least one of O₂ and N₂O. O₂ or N₂O can react chemically with silicon carbide to produce SiO₂, and also release CO₂. Therefore, the modified layer may be a SiO₂ layer.

Specifically, the process of taking the mask layer as a shield and modifying the exposed surface of the structure to be etched by using the oxidizing gas to form the modified layer may include taking the mask layer as a shield and modifying the exposed surface of the structure to be etched by using an oxidizing gas and an inert gas to form the modified layer. The inert gas assists in the removal of by-products. The inert gas may include at least one of Ar, He, Kr, and N₂, and the proportion of the inert gas in the total intake flow of the oxidizing gas and the inert gas may be less than or equal to 80%.

In a possible implementation, the method of Atomic Layer Etching (ALE) may be used for modification and subsequent etching processes. ALE is a cyclic thin-film etching process based on surface modification and volatile release, capable of achieving etching precision down to a single atomic layer, approximately 0.4 nm. The etching process may be carried out uniformly, atomic layer by atomic layer, and stopped at the appropriate time or position, thereby achieving an extremely high etching selectivity ratio.

To more precisely control the etching amount, modification and etching may be performed once or multiple times to form a groove of a preset depth. Each time the exposed surface of the structure to be etched is modified, the target depth to be etched may be predetermined, and the process parameters during modification may thus be determined to ensure that the thickness of the modified layer meets the target depth.

Specifically, the process of taking the mask layer as a shield and modifying the exposed surface of the structure to be etched by using the oxidizing gas to form the modified layer may include determining the density of the first plasma, the energy of the first plasma, and the temperature of the structure to be etched based on the target depth of the structure to be etched each time; forming the first plasma by ionizing the oxidizing gas; and taking the mask layer as a shield, and modifying the exposed surface of the structure to be etched with the oxidizing gas based on the density of the first plasma, the energy of the first plasma, and the temperature of the structure to be etched, thereby forming a modified layer of the target depth. In this way, by controlling the temperature of the structure to be etched or the density and energy of the plasma formed from the oxidizing gas, the oxidation rate of the surface atoms of silicon carbide can be controlled, precisely controlling the thickness of the modified layer on the silicon carbide surface, and achieving controllable etching processes and etching amounts.

Specifically, when an oxidizing gas is used to modify the exposed surface of the structure to be etched, the pressure in the reaction chamber may be greater than or equal to 5 mT and less than or equal to 80 mT. The radio frequency (RF) power of the first RF source may be less than or equal to 800 W, whereas the RF power of the second RF source may be 0. The first RF source is used to ionize the oxidizing gas to form the first plasma, and the second RF source is used to control the downward movement of the first plasma to contact the structure to be etched.

Specifically, if the structure to be etched includes silicon carbide material, the pressure in the reaction chamber may be 80 mT; the RF power of the first RF source may be 400 W; the oxidizing gas may include O₂; the flow rate of the oxidizing gas may be 100 sccm; and the modification time for modifying the exposed surface of the structure to be etched using the oxidizing gas may be 10 seconds.

At S103, the modified layer may be removed by using an etching gas while taking the mask layer as a shield, so as to form a trench.

In an embodiment of the present application, it is possible to remove the modified layer by using the etching gas while taking a mask layer as a shield so as to form a trench. By firstly forming the modified layer and then removing it to create the trench, the unmodified portion of the structure to be etched is hardly etched, allowing the etching to stop at an appropriate position and achieving precise control of the etching amount. Furthermore, since the trench is formed by etching the modified layer, the unmodified portion of the structure to be etched is not over-etched. In this way, the formation of micro-trenches may be avoided, thereby reducing electrical damage and improving device performance. As shown in FIG. 5, which shows a schematic structural view of a trench formed in the structure to be etched provided by an embodiment of the present application, the modified layer 103 is etched away to form the trench 104.

Specifically, if the structure to be etched includes silicon carbide (SiC) material, the etching gas may include at least one of CH₂F₂, CHF₃, CF₄, C₄F₈, SF₆, and HBr. This enables selective removal of the SiO₂ modified layer with high selectivity ratio to the underlying SiC. The process exhibits self-limiting behavior, and almost no etching is carried out on SiC.

Specifically, the etching gas may also include an inert gas to assist in the removal of by-products. The inert gas may include at least one of Ar, He, Kr, and N₂, and its proportion in the etching gas may be less than or equal to 80%.

In a possible implementation, before removing the modified layer by using the etching gas while taking the mask layer as a shield so as to form trenches, a purging process may be carried out to eliminate residual oxidizing gases and generated byproducts in the reaction chamber, thus maintaining a good etching environment. Specifically, it is possible to terminate supply of the oxidizing gas to the reaction chamber where the structure to be etched is located, to turn off the first RF source, to introduce the argon gas into the reaction chamber for purging, and to vacuum the reaction chamber. Here, the first RF source is used to ionize the oxidizing gas to form the first plasma.

In a possible implementation, after removing the modified layer by using the etching gas while taking the mask layer as a shield so as to form trenches, a purging process may be conducted again to remove residual etching gas and the like, leaving the reaction chamber in a vacuum state for subsequent operations. Specifically, it is possible to terminate the supply of the etching gas into the reaction chamber, to turn off both the first and second RF sources, to introduce the argon gas into the reaction chamber for purging, and to vacuum the reaction chamber. Here, the first RF source is used to ionize the etching gas to form the second plasma, and the second RF source is used to control the downward movement of the second plasma to contact the structure to be etched, achieving anisotropic etching.

Specifically, the structure to be etched is placed into the reaction chamber of the ICP processing equipment, where the surface of the structure to be etched is modified by using the oxidizing gas. After the modification, a purging step is carried out; the first RF source is turned off; and the chamber is vacuumized to reset the chamber environment. Subsequently, the modified layer is etched by using the etching gas. After the etching, another purging step is performed; the first and second RF sources are turned off; and the chamber is vacuumized to reset the chamber environment.

Specifically, when removing the modified layer by using the etching gas, the pressure in the reaction chamber may be greater than or equal to 5 mT and less than or equal to 80 mT. The RF power of the first RF source may be greater than or equal to 200 W and less than or equal to 1200 W, which may reduce electrical damage. The RF power of the second RF source may be less than or equal to 500 W. During the etching phase, the first RF source is used to ionize the etching gas to form the second plasma, and the second RF source is used to control the downward movement of the second plasma to contact the structure to be etched. In this way, by controlling the process parameters, a rounded connection between the bottom and sidewall of the trench can be achieved, avoiding the formation of micro-trenches and improving process quality.

Specifically, if the structure to be etched includes silicon carbide material, the pressure in the reaction chamber may be 30 mT; the RF power of the first RF source may be 400 W; the RF power of the second RF source may be 20 W; the etching gas may include SF₆; the flow rate of the etching gas may be 100 sccm; and the etching time for removing the modified layer by using the etching gas may be 10 seconds.

In an embodiment of the present application, the untreated part of the structure to be etched can be directly modified and etched to obtain trenches with a surface roughness Ra of less than 0.5 nm. Referring to FIG. 6, it shows an electron microscope image of a part of a trench provided by an embodiment of the present application. The trench 104 has a rounded connection between its bottom and sidewall, with no micro-trench present.

In an embodiment of the present application, the operations of modifying and etching the structure to be etched can serve as an electrical repair step after a conventional ICP etching process, effectively removing lattice damage, improving subsequent processing quality, and enhancing electrical performance.

Specifically, before using the mask layer as a shield and modifying the exposed surface of the structure to be etched with an oxidizing gas to form a modified layer, the structure to be etched can be subjected to plasma etching by using a third plasma obtained by ionizing a reaction gas, with the mask layer serving as a shield. The reaction gas may include SF₆, O₂, and Ar, thereby repairing lattice damage caused during the ICP etching process, reducing surface roughness, and making the trench bottom smoother.

For example, after using the ICP process to etch, a trench having a depth of 1µm is formed, and the modification and etching processes are then performed. During the modification process, the pressure in the reaction chamber is 80 mT; the RF power of the first RF source is 400 W; the oxidizing gas includes O₂; the flow rate of the oxidizing gas is 100 sccm; and the modification time by using the oxidizing gas to modify the exposed surface of the structure to be etched is 10 seconds. Subsequently, during the etching process, the pressure in the reaction chamber is 30 mT; the RF power of the first RF source is 400 W; the RF power of the second RF source is 20 W; the etching gas includes SF₆; the flow rate of the etching gas is 100 sccm; and the etching time using the etching gas to remove the modified layer is 10 seconds. 10 cycles of the etching process is carried out. The surface roughness of the trench may be changed from Ra = 1.23 nm to Ra = 0.43 nm, thus reducing the surface roughness.

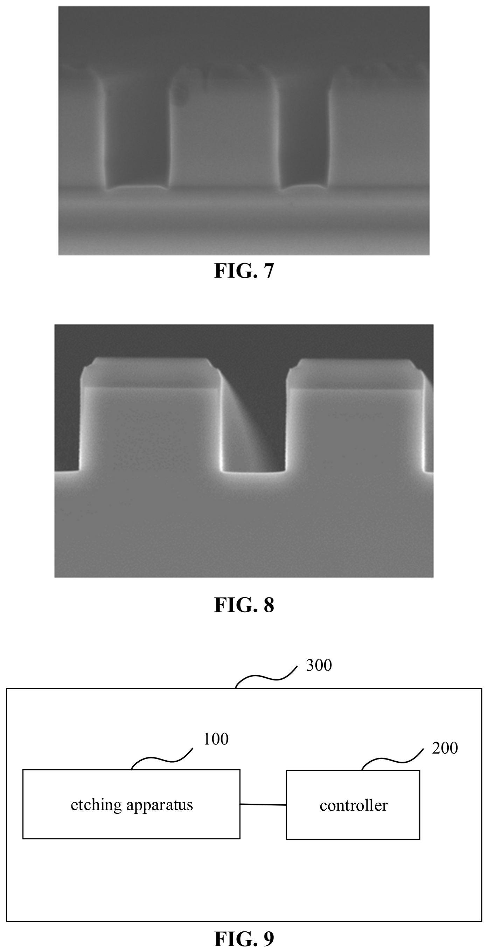

Referring to FIG. 7, showing an electron microscope image of a trench etched by ICP process provided by an embodiment of the present application, micro-trenches present at the bottom of the sidewalls of the trench. Referring to FIG. 8, showing an electron microscope image of a trench etched by ALE process which follows the ICP process provided by an embodiment of the present application, no micro-trenches present at the bottom and sidewalls of the trench, and thus the trench is improved in shape.

In an embodiment of the present application, the structure to be etched may undergo modification and etching processes multiple times repeatedly. By increasing the number of times of etching, the depth of the trench can be more precisely controlled. The trenches of different depths may be obtained and the shape quality of the trenches may be improved.

Specifically, the operation of using the mask layer as a shield and modifying the exposed surface of the structure to be etched with an oxidizing gas to form a modified layer, and the operation of then using the mask layer as a shield and removing the modified layer with an etching gas to form a trench, may be repeated until the depth of the trench reaches a preset depth.

Specifically, the depth of the trench is linearly related to the number of repeated operations. The number of repeated operations may be determined based on the preset depth of the trench and the etching thickness of each etching. In other words, based on the preset depth of the trench, it is possible to determine the number of the times to repeat the operation of using the mask layer as a shield and modifying the exposed surface of the structure to be etched with an oxidizing gas to form a modified layer, and the operation of then using the mask layer as a shield and removing the modified layer with an etching gas to form a trench.

For example, during the modification process, the pressure in the reaction chamber is 80 mT; the RF power of the first RF source is 400 W; the oxidizing gas includes O₂ with a flow rate of 100 sccm; and the modification time using the oxidizing gas to modify the exposed surface of the structure to be etched is 10 seconds. Subsequently, during the etching process, the pressure in the reaction chamber is 30 mT; the RF power of the first RF source is 400 W; the RF power of the second RF source is 20 W; the etching gas includes SF₆ with a flow rate of 100 sccm; and the etching time to remove the modified layer by using the etching gas is 10 seconds. After 100 cycles, an etching depth of 70nm for the trench can be achieved.

In an embodiment of the present application, the plasma processing equipment has the function of automatically and cyclically executing the specified steps and purge steps. The RF source used in the plasma processing equipment has the capability of stable power output within the range of 0-50W. Additionally, the RF source used in the plasma processing equipment should have pulsing functionality and the ability to control the duty cycle.

An etching method is provided according to an embodiment of the present application, which involves providing a structure to be etched, covering a patterned mask layer on the structure to be etched, modifying the exposed surface of the structure to be etched by using an oxidizing gas while taking the mask layer as a shield so as to form a modified layer, and then removing the modified layer by using an etching gas while taking the mask layer as a shield so as to form a trench. In this way, by firstly forming a modified layer and then removing it to form a trench, the unmodified part of the structure to be etched is hardly etched, allowing the etching to stop at an appropriate position and achieving precise control of the etching amount. Furthermore, since the trench is formed by etching the modified layer, the unmodified part of the structure to be etched is not over-etched, which may also avoid the formation of micro-trenches, thereby reducing electrical damage and improving device performance.

Based on the above etching method, an etching system is further provided according to the embodiments of the present application. With reference to FIG. 9, it shows a schematic structural view of an etching system provided by an embodiment of the present application. The etching system 300 may include an etching apparatus 100 and a controller 200. The etching apparatus 100 is used for modifying the exposed surface of the structure to be etched by using an oxidizing gas to form a modified layer, and for removing the modified layer by using an etching gas to form a trench. The controller 200 is used for executing the etching method.

The etching system provided according to the embodiments of the present application includes an etching apparatus and a controller. The etching apparatus is used for modifying the exposed surface of the structure to be etched by using an oxidizing gas to form a modified layer, and for removing the modified layer by using an etching gas to form a trench. The controller is used for the etching method. By firstly forming a modified layer and then removing it to form a trench, the unmodified part of the structure to be etched is hardly etched, allowing the etching to stop at an appropriate position and achieving precise control of the etching amount. Furthermore, since the trench is formed by etching the modified layer, the unmodified part of the structure to be etched is not over-etched, which can also avoid the formation of micro-trenches, thereby reducing electrical damage and improving device performance.

The above embodiments in this specification are described in a progressive manner. References may be made among these embodiments with respect to the same or similar portions among these embodiments, and each of the embodiments is mainly focused on describing its differences from other embodiments. Especially, for the apparatus embodiments, since they are similar with the method embodiments, the description of the apparatuses is simple, and reference may be made to the relevant part of the method embodiments.

The preferred embodiments according to the present application are disclosed above, and are not intended to limit the present application. With the method and technical content disclosed above, those skilled in the art can make some variations and improvements to the technical solutions of the present application, or make some equivalent variations on the embodiments without departing from the scope of technical solutions of the present application. All simple modifications, equivalent variations and improvements made based on the technical essence of the present application without departing the content of the technical solutions of the present application fall within the protection scope of the technical solutions of the present application.

## Claims

1. An etching method, comprising:
providing a structure to be etched, wherein the structure to be etched is covered with a patterned mask layer;
modifying an exposed surface of the structure to be etched by using an oxidizing gas while taking the mask layer as a shield, so as to form a modified layer; and
removing the modified layer by using an etching gas while taking the mask layer as the shield, so as to form a trench.

2. The method according to claim 1, wherein the structure to be etched comprises silicon carbide material, and the oxidizing gas comprises at least one of O₂ and N₂O.

3. The method according to claim 2, wherein the step of modifying the exposed surface of the structure to be etched by using the oxidizing gas while taking the mask layer as the shield so as to form the modified layer comprises:
modifying the exposed surface of the structure to be etched by using the oxidizing gas and an inert gas while taking the mask layer as the shield so as to form a modified layer, wherein the inert gas comprises at least one of Ar, He, Kr, and N₂, and the proportion of the inert gas in total intake flow of the oxidizing gas and the inert gas is less than or equal to 80%.

4. The method according to claim 1, wherein the structure to be etched comprises silicon carbide material, and the etching gas comprises at least one of CH₂F₂, CHF₃, CF₄, C₄F₈, SF₆, and HBr.

5. The method according to claim 4, wherein the etching gas comprises an inert gas, the inert gas comprises at least one of Ar, He, Kr, and N₂, and the proportion of the inert gas in the etching gas is less than or equal to 80%.

6. The method according to claim 1, wherein before the step of removing the modified layer by using the etching gas while taking the mask layer as the shield so as to form the trench, the method further comprises:
ceasing supply of the oxidizing gas into a reaction chamber where the structure to be etched is located, turning off a first radio frequency source, introducing argon gas into the reaction chamber for purging, and vacuuming the reaction chamber, wherein the first radio frequency source is configured to ionize the oxidizing gas to form a first plasma; and
after the step of removing the modified layer by using the etching gas while taking the mask layer as the shield so as to form the trench, the method further comprises:
ceasing supply of the etching gas into the reaction chamber, turning off both the first radio frequency source and a second radio frequency source, introducing the argon gas into the reaction chamber for purging, and vacuuming the reaction chamber, wherein the first radio frequency source is further configured to ionize the etching gas to form a second plasma, and the second radio frequency source is configured to control a downward movement of the second plasma to contact the structure to be etched.

7. The method according to claim 1, further comprising:
repeatedly performing the step of modifying the exposed surface of the structure to be etched by using the oxidizing gas while taking the mask layer as the shield so as to form a modified layer, and the step of removing the modified layer by using the etching gas while taking the mask layer as the shield so as to form a trench, until a depth of the trench reaches a preset depth.

8. The method according to claim 7, further comprising:
Determining, based on preset depth of the trench, the number of repetitions of the step of modifying the exposed surface of the structure to be etched by using the oxidizing gas while taking the mask layer as the shield so as to form a modified layer, and the step of removing the modified layer by using the etching gas while taking the mask layer as the shield so as to form a trench.

9. The method according to any one of claims 1 to 8, wherein the step of modifying the exposed surface of the structure to be etched by using the oxidizing gas while taking the mask layer as the shield so as to form the modified layer comprises:
determining a density of the first plasma, an energy of the first plasma, and a temperature of the structure to be etched based on a target depth for each etching of the structure to be etched, the first plasma being formed by ionizing the oxidizing gas; and
modifying the exposed surface of the structure to be etched by using the oxidizing gas while taking the mask layer as the shield based on the density of the first plasma, the energy of the first plasma, and the temperature of the structure to be etched, so as to form a modified layer of the target depth.

10. The method according to claim 9, wherein, when modifying the exposed surface of the structure to be etched by using an oxidizing gas, a pressure in a reaction chamber is greater than or equal to 5 mT and less than or equal to 80 mT, a radio frequency power of a first radio frequency source is less than or equal to 800 W, a radio frequency power of a second radio frequency source is 0, the first radio frequency source is configured to ionize the oxidizing gas to form a first plasma, and the second radio frequency source is configured to control a downward movement of the first plasma to contact the structure to be etched.

11. The method according to claim 10, wherein the structure to be etched comprises silicon carbide material, the pressure in the reaction chamber is 80 mT, the radio frequency power of the first radio frequency source is 400 W, the oxidizing gas comprises O₂, a flow rate of the oxidizing gas is 100 sccm, and a modification time for modifying the exposed surface of the structure to be etched by using the oxidizing gas is 10 seconds.

12. The method according to any one of claims 1 to 8, wherein, when removing the modified layer by using the etching gas, a pressure in a reaction chamber is greater than or equal to 5 mT and less than or equal to 80 mT, a radio frequency power of a first radio frequency source is greater than or equal to 200 W and less than or equal to 1200 W, a radio frequency power of a second radio frequency source is less than or equal to 500 W, the first radio frequency source is configured to ionize the etching gas to form a second plasma, and the second radio frequency source is configured to control a downward movement of the second plasma to contact the structure to be etched.

13. The method according to claim 12, wherein the structure to be etched comprises silicon carbide material, the pressure in the reaction chamber is 30 mT, the radio frequency power of the first radio frequency source is 400 W, the radio frequency power of the second radio frequency source is 20 W, the etching gas comprises SF₆, a flow rate of the etching gas is 100 sccm, and an etching time for removing the modified layer by using the etching gas is 10 seconds.

14. The method according to any one of claims 1 to 8, wherein before the step of modifying the exposed surface of the structure to be etched by using the oxidizing gas while taking the mask layer as the shield so as to form the modified layer, the method further comprises:
performing plasma etching on the structure to be etched with a third plasma obtained by ionizing the reaction gas while taking the mask layer as the shield.

15. The method according to claim 14, wherein the reaction gas comprises SF₆, O₂, and Ar.

16. The method according to any one of claims 1 to 8, further comprising:
forming the patterned mask layer on the structure to be etched by using nanoimprinting, photolithography, or etching process.

17. The method according to any one of claims 1 to 8, wherein material of the mask layer is at least one of photoresist, silicon oxide, silicon nitride, and metal.

18. The method according to any one of claims 1 to 8, wherein a reaction chamber, where the structure to be etched is located, is a chamber of inductively coupled plasma processing equipment.

19. The method according to any one of claims 1 to 8, wherein the structure to be etched comprises a silicon carbide substrate, or the structure to be etched comprises a substrate and a silicon carbide layer located on a side of the substrate; and the modified layer is a silicon oxide layer.

20. An etching system, comprising an etching apparatus and a controller, wherein
the etching apparatus is configured to modify an exposed surface of a structure to be etched by using an oxidizing gas to form a modified layer, and to remove the modified layer by using an etching gas to form a trench, and the controller is configured to execute the etching method according to any one of claims 1 to 19.
